# EUROPÄISCHE PATENTSCHRIFT

(11) **EP 0 514 388 B1**
(45) Veröffentlichungstag und Bekanntmachung des Hinweises auf die Patenterteilung: **30.11.1994**
(21) Anmeldenummer: 91901774.9
(22) Anmeldetag: 18.12.1990
(51) Int. Cl.: H03J 7/04

(54) **VERFAHREN ZUM ABGLEICH ANALOGER SCHALTUNGSTEILE INNERHALB EINER INTEGRIERTEN SCHALTUNG**
METHOD FOR ADJUSTING ANALOG CIRCUIT PARTS IN AN INTEGRATED CIRCUIT
PROCEDE D'AJUSTAGE D'ELEMENTS DE CIRCUIT ANALOGIQUE A L'INTERIEUR D'UN CIRCUIT INTEGRE

(30) Priorität: 05.02.1990 DE 4003417
(43) Veröffentlichungstag der Anmeldung: 25.11.1992
(73) Patentinhaber: Deutsche Thomson-Brandt GmbH, 78003 Villingen-Schwenningen (DE)
(72) Erfinder: Koblitz, Rudolf, W-7730 Villingen (DE); Rieger, Martin, W-7210 Rottweil-Neukirch (DE)
(86) Internationale Anmeldenummer: EP9002226
(87) Internationale Veröffentlichungsnummer: WO9111857

(56) Entgegenhaltungen:
- EP-A- 0 273 365
- DE-A-37 237 78
- GB-A- 2 071 958
- I.E.E.E. TRANSACTIONS ON CONSUMER ELECTRONICS, "1988 Internat. Conference on Consumer Electronics, Part 1", vol. 34, No. 3, Aug. 1988 (New York, NY, US). Y. Yamamoto et al.: "A new audio processor for EIAJ MTS", p. 625-632.
- I.E.E.E. International Conference on Consumer Electronics, Digest of Technical Papers, ICCE, 8-10 June 1988, Rosemont (US). Y. Yamamoto et al.: "A new video processor for color tv", P. 250-251.

## Beschreibung

Die Erfindung betrifft ein Verfahren zum Abgleich analoger Schaltungsteile innerhalb einer integrierten Schaltung.

Für die Herstellung von 'one chip'-Fernsehempfängern müssen in integrierten Schaltkreisen enthaltene analoge Schaltungen, z.B. Filter, bedingt durch Bauelementetoleranzen und Fertigungsstreuungen, abgeglichen werden. Aus der Schrift von Y.P. Tsividis, "MOS Analog IC Design - New Ideas, Trends and Obstacles", ESSCIRC'86, Delft Conference Proceedings, ist es bekannt, ein Referenzelement einer integrierten Schaltung, welches schaltungstechnisch ähnlich wie andere abzugleichende Elemente der integrierten Schaltung aufgebaut ist, abzugleichen und damit ein Maß für einen zumindest näherungsweisen Abgleich der anderen abzugleichenden Elemente zu erhalten. Der Abgleich dieses Referenzelements bedeutet aber einen zusätzlichen Aufwand. Außerdem werden Bauteile-Toleranzen innerhalb der integrierten Schaltung damit nicht berücksichtigt.

Die Schrift I.E.E.E. Transactions on Consumer Electronics, "1988 International Conference on Consumer Electronics, Part 1", Band 34, Nr. 3, August 1988 (New York, NY, US) Y. Yamamoto et al.: "A new audio processor for EIAJ MTS", Seiten 625-632 beschreibt zweitere Verfahren zum Abgleich von mehrenen Schaltungsteilen in analogen Schaltungen.

Der Erfindung liegt die Aufgabe zugrunde, analoge Schaltungsteile innerhalb einer integrierten Schaltung mit geringem Aufwand und mit hoher Genauigkeit abzugleichen.

Diese Aufgabe wird durch die im Patentanspruch 1 angegebenen Merkmale gelöst. Vorteilhafte Weiterbildungen der Erfindung sind in den Unteransprüchen angegeben.

Es wird ein Referenz-Schaltungsteil des integrierten Schaltkreises, der auch in bekannten Fernsehempfängern vorhanden ist und abgeglichen werden muß, schaltungstechnisch ähnlich den anderen abzugleichenden analogen Schaltungsteilen aufgebaut. Dieser Referenz-Schaltungsteil ist beispielsweise ein Horizontalfrequenz-Oszillator und die anderen analogen Schaltungsteile sind z.B. Analogfilter, FM-Demodulatoren und Equalizer.
Diese Schaltungsteile sind jeweils z.B. durch einen Strom abgleichbar. Der eingestellte Strom für den Horizontalfrequenz-Oszillator ist dabei ein Maß für den entsprechenden Abgleich-Strom der analogen Schaltungsteile.
Eine Regelung für einen Feinabgleich der analogen Schaltungsteile braucht nun den Strom nur noch geringfügig zu ändern und muß nur noch einen stark eingeschränkten Fangbereich haben. Auf diesen Regelvorgang haben z.B. Rauschen und Bauteiletoleranzen vorteilhaft nur noch einen geringen Einfluß. Es gibt keine Probleme mit dem 'Fangen' der Regelschaltung. Vorteilhaft können durch die Integration dieser Schaltungsteile gegenüber bekannten Fernsehempfängern teuere keramische Filter und LC-Kreise entfallen.

Nachstehend wird ein Ausführungsbeispiel der Erfindung anhand der Zeichnungen erläutert. Diese zeigen in:
- Fig. 1: Blockschaltbild eines erfindungsgemäßen Multistandard-Fernseh-Chassis,
- Fig. 2: Blockschaltbild eines in dem Multistandard-Fernseh-Chassis enthaltenen Signalprozessors,
- Fig. 3: eine analoge Biquad-Basisfilterzelle,
- Fig. 4: einen gm-Verstärker, Typ 1,
- Fig. 5: einen gm-Verstärker, Typ 2,
- Fig. 6: einen erfindungsgemäßen Abgleich-Baum.

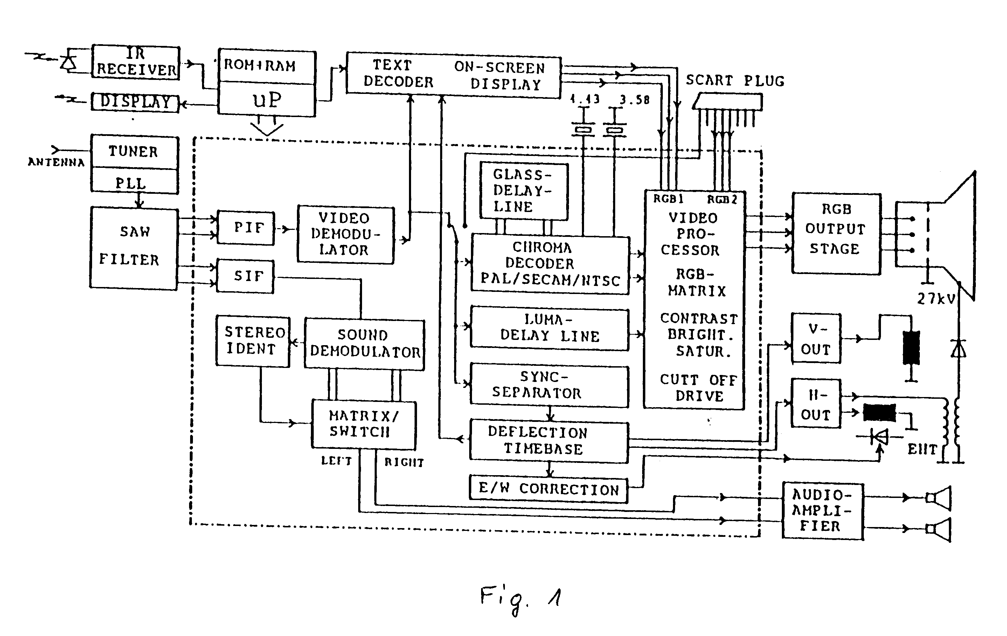

Fig. 1 zeigt das Blockschaltbild eines Fernsehempfängers. Die Baugruppen entsprechen im Prinzip denen heutiger Fernsehempfänger. PIF bedeutet Bild-ZF, SIF bedeutet Ton-ZF. Im Fernseh-Chassis gemäß der Erfindung sind jedoch die Baugruppen innerhalb der Strichpunkt-Markierung mit den darin befindlichen abzugleichenden analogen Schaltungsteilen in einem einzigen integrierten Schaltkreis ('one chip') enthalten.

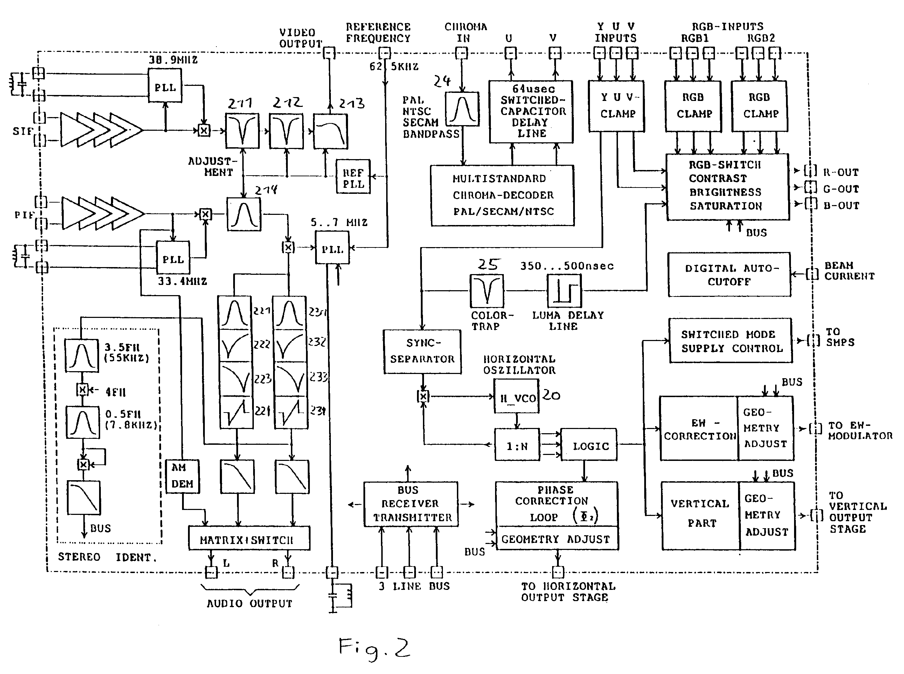

In Fig. 2 ist ein detaillierteres Blockschaltbild des integrierten Schaltkreises mit verschiedenen abzugleichenden Schaltungsteilen dargestellt. Diese Schaltungsteile sind mit 20 (Horizontalfrequenz-Oszillator), 211 - 214 (ZF-Filter), 221 - 224, 231 - 234 (Filter für Ton), 24 (Chroma-Glockenfilter) und 25 (Chromafalle) bezeichnet.

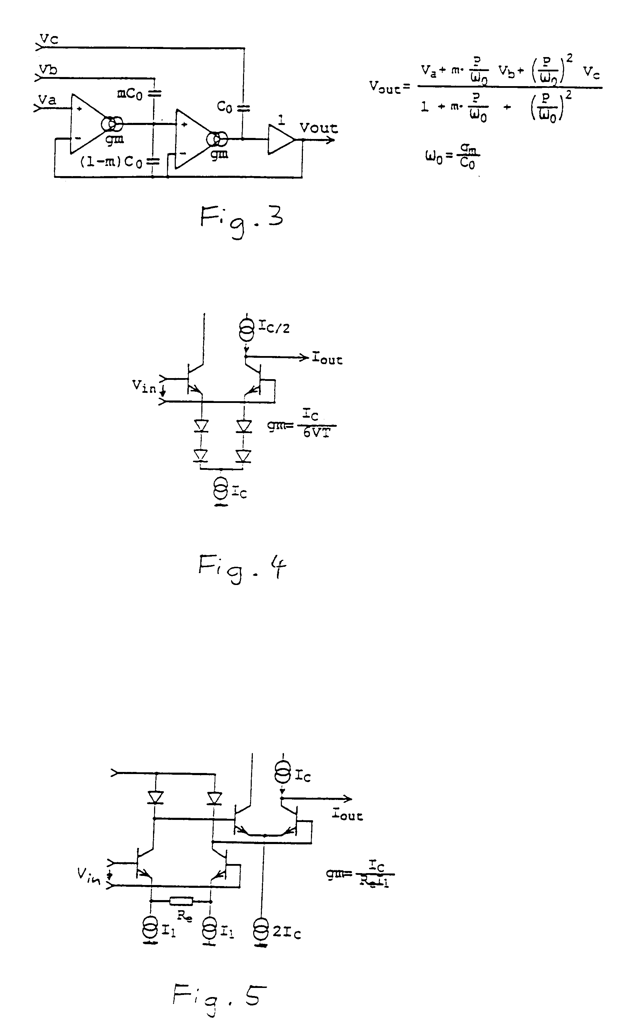

Fig. 3 zeigt eine in dem integrierten Schaltkreis mehrfach verwendete analoge Biquad-Basisfilterzelle mit der zugehörigen Übertragungsfunktion Vout. Die folgende Tabelle zeigt die verschiedenen Filter-Charakteristiken dieser Basisfilterzelle in Abhängigkeit von der Beschaltung der Eingangsanschlüsse Va, Vb und Vc.
- Tiefpaß:: Vb und Vc an Masse, Va an Eingangssignal
- Hochpaß:: Va und Vb an Masse, Vc an Eingangssignal
- Bandpaß:: Va und Vc an Masse, Vb an Eingangssignal
- Falle :: Vb an Masse, Va und Vc an Eingangssignal

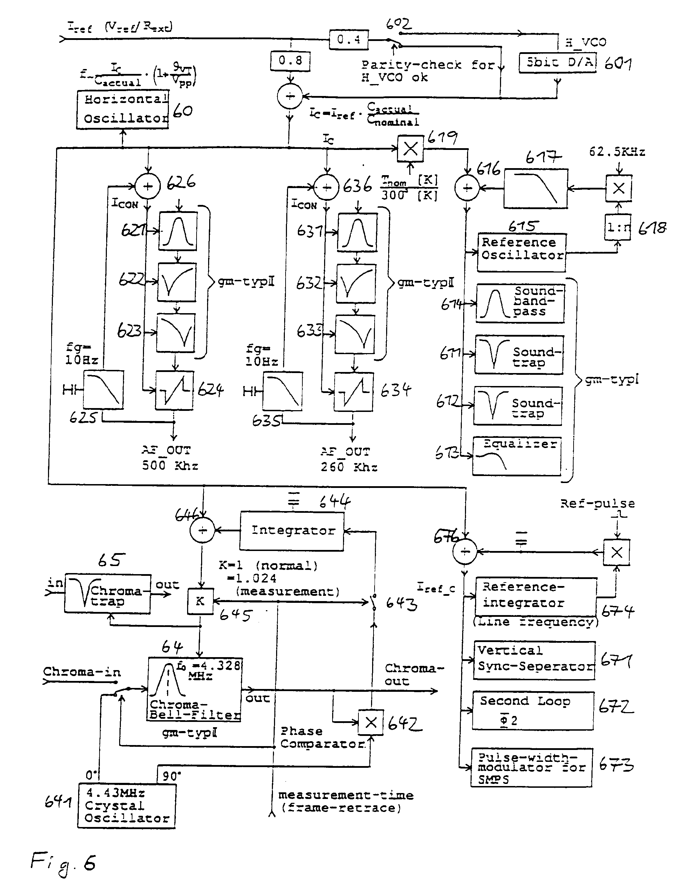

Die Biquad-Basisfilterzelle aus Fig. 3 enthält zwei gm-Verstärker (Transconduktanz-Verstärker), die eine Schaltung entsprechend Fig. 4 oder Fig. 5 haben. Gm-Verstärker Typ 1 kann höhere Frequenzen verarbeiten als gm-Verstärker Typ 2. Um die verarbeitbare Signalamplitude für den gm-Verstärker Typ 1 zu vergrößern, sind in Reihe mit den Emittern in Fig. 4 jeweils zwei Dioden hinzugefügt. Durch eine andere Beschaltung kann der gm-Verstärker Typ 2 in Fig. 5 noch höhere Signalamplituden verarbeiten und hat eine geringere Temperaturabhängigkeit, erfordert aber einen etwas erhöhten Bauelementeaufwand. In der integrierten Schaltung gemäß Fig. 2 werden beide gm-Verstärkertypen benutzt.
Entsprechend des Wertes der Kapazität CO läßt sich die Mittenfrequenz der Biquad-Basisfilterzelle nach Fig. 3 nun vorteilhaft einfach über den Strom Ic bzw. die Ströme Ic und 11 abgleichen gemäß der in den Figuren 3 - 5 angegebenen Gleichungen. Vt ist die bekannte Temperaturspannung und hat einen Wert von 26 mV/K.

Der Abgleich-Baum in Fig. 6 zeigt den Horizontalfrequenz-Oszillator 60. Er ist der Referenz-Schaltungsteil. Seine Frequenz kann leicht gemessen und mit Hilfe des 5-Bit-D/A-Wandlers 601 mit einem Fehler von kleiner +- 1 % abgeglichen werden. Der D/A-Wandler 601 ist bei der Fernsehgeräte-Produktion softwaremäßig abgleichbar, der Abgleich ist dann gespeichert.
Durch hohe Spannungsstöße in der Umgebung dieses D/A-Wandlers kann der Speicherinhalt in unerwünschter Weise geändert werden. Wenn dadurch die Horizontalfrequenz zu niedrig würde, könnte die Horizontalendstufe und ein Switch-Mode-Netzteil zerstört werden. Darum wird im D/A-Wandler 601 eine Parity-Prüfung durchgeführt. Wenn diese Prüfung einen Fehler ergibt, wird durch Schalter 602 ein maximaler Steuerstrom eingestellt. Dadurch erhöht sich die Horizontalfrequenz und eine Zerstörung von Schaltungen wird verhindert.

Wenn der Horizontalfrequenzoszillator 60 abgeglichen ist, ergibt sich der Steuerstrom Ic aus dem Referenzstrom Iref = Vref / Rext . Bedingt durch Herstellungstoleranzen haben z.B. die Kondensatoren in der integrierten Schaltung einen tatsächlichen Wert Cactual im Vergleich zu einem Sollwert Cnominal. Dadurch ist der Steuerstrom Ic kapazitäts-abgeglichen ('capacitor-adjusted') und hat z.B. den Wert Ic = Iref * Cactual / Cnominal . Cactual wird praktisch indirekt über die Frequenzmessung des Horizontalfrequenzoszillators 60 gemessen.
Die Ausgangsfrequenz des Horizontalfrequenz-Oszillators ist zwar im Wesentlichen abhängig vom Steuerstrom Ic, hat aber z.B. auch noch eine geringe Abhängigkeit von der Temperaturspannung Vt und der Spitze-Spitze-Ausgangsspannung Vpp . Dadurch ergibt sich diese Frequenz zu ca. Ic / Cactual * (1 + 9 * Vt / Vpp) und folglich die Notwendigkeit, bestimmte, vom Steuerstrom Ic abgeglichene, analoge Schaltungsteile noch einem Feinabgleich zu unterziehen.

Aus diesem Grunde sind in der integrierten Schaltung fünf Regelschleifen für verschiedene Schaltungsteile vorhanden, in denen der Steuerstrom Ic in seinen jeweiligen Anteilen mit einem Korrekturstrom (Icon) in den Summationspunkten 616, 626, 636, 646 und 676 verknüpft wird.

Die Analogfilter 621 - 623 und der FM-Demodulator 624 bereiten einen ersten Tonkanal auf, die Analogfilter 631 - 633 und der FM-Demodulator 634 bereiten einen zweiten Tonkanal auf. Das Kriterium für den Feinabgleich der beiden Tonkanäle ist der Gleichspannungs-Offset an den Ausgängen der FM-Demodulatoren 624 bzw. 634. Die Ausgangsspannungen werden in den Tiefpässen 625 bzw. 635 mit einer Grenzfrequenz von 10 Hz gefiltert. Die sich ergebenden Gleichspannungsanteile erzeugen jeweils den Korrekturstrom Icon.

Der Feinabgleich der Ton-Fallen 611 - 612 und des Equalizers 613 in der Bild-ZF und des Vorselektionsfilters 614 in der Ton-ZF wird mit Hilfe eines zusätzlichen Referenz-Biquad-Filters 617 durchgeführt, welches in der Rückkopplung einer PLL-Schleife angeordnet ist. Die PLL-Schleife beinhaltet einen Referenzoszillator 615 und einen programmierbaren 1:n-Teiler 618. Dabei liegt die Grenzfrequenz des Referenz-Biquad-Filters 617 passend zur Frequenzlage der Ton-Fallen 611 - 612, des Equalizers 613 und des Vorselektionsfilters 614, sodaß sich ein guter Gleichlauf ergibt.
Weil für die Ton-Fallen 611 - 612, den Equalizer 613 und das Vorselektionsfilter 614 wegen der hohen zu verarbeitenden Frequenzen gm-Verstärker Typ 1 verwendet werden, wird der Steuerstrom Ic noch in der Schaltung 619 einer temperaturabhängigen Korrektur unterworfen.

Beim Feinabgleich des Chroma-Glockenfilters 64 darf nur ein Fehler von maximal +- 0.4 % auftreten. Außerdem muß die Güte des Chroma-Glockenfilters 64 den Wert sechzehn erreichen. Darum wird ein unterschiedliches Feinabgleich-Verfahren angewandt. Während des vertikalen Zeilenrücklaufs (frame) wird dieses Filter in einen Abgleich-Mode umgeschaltet. Ein Quartzoszillator 641 mit der PAL-Farbträgerfrequenz 4.43 MHz wird an das Filter angelegt und in einem Phasenkomparator 642 die Phase am Ein- und Ausgang des Filters verglichen. Wenn die Phasendifferenz null ist, stimmt die Mittenfrequenz des Chroma-Glockenfilters 64 mit der PAL-Farbträgerfrequenz überein. Der Phasenkomparator 642 ist mit einer Abtast- und Halteschaltung 643 verbunden. Weil geringe Leckströme erforderlich sind, hat die Abtast- und Halteschaltung 643 Operationsverstärker mit NMOS-Eingängen (nicht dargestellt). Es schließt sich ein Integrator 644 an, der den Korrekturstrom für den Steuerstrom Ic erzeugt. Zusätzlich wird während der Meßzeit durch die Korrekturschaltung 645 ein kleiner Korrekturfaktor von ca. 2.3 % eingeführt, weil die Soll-Mittenfrequenz (4.328 MHz) des Chroma-Glockenfilters 64 etwas von der FAL-Farbträgerfrequenz (4.43 MHz) abweicht.
Der Abgleich der Farbträgerfalle 65 ist weniger kritisch. Es wird der gleiche Steuerstrom wie für das Chroma-Glockenfilter 64 verwendet.

Der Steuerstrom-Korrekturwert für einen vertikalen Sync-Separator 671, eine Phi2-Schleifenschaltung 672 und einen Pulsweitenmodulator 673 für ein Switch-Mode-Netzteil wird über eine weitere PLL-Schleife mit einem Referenzintegrator 674 gewonnen.

Das beschriebene Abgleichverfahren mit dem selbsttätigen Feinabgleich ist für integrierte Schaltungen in Bipolar- und BICMOS-Technologie geeignet.
Durch den zusätzlichen Feinabgleich wird vorteilhaft auch eine Temperaturabhängigkeit der Schaltungsteile eliminiert.

## Patentansprüche

1. Verfahren zum Abgleich analoger Schaltungsteile inner halb einer integrierten Schaltung mit einem Steuerstrom (Ic) für in den Schaltungsteilen enthaltene Bauelemente und mit einem gemeinsamen GrobAbgleich mehrerer Schaltungsteile, wobei ein dem Betrag des Steuerstromes entsprechender Wert (Iref) in der integrierten Schaltung oder in einer Vorrichtung, die diese integrierte Schaltung enthält, gespeichert wird, **dadurch gekennzeichnet**, daß der erforderliche Steuerstrom durch den Abgleich eines Referenz-Schaltungsteiles (60) der integrierten Schaltung ermittelt wird und daß während des Betriebs der integrierten Schaltung automatisch ein zusätzlicher Fein-Ahgleich eines anderen Schaltungsteiles oder mehrerer anderer Schaltungsteile (621-624, 631-634, 614-613, 671-674, 64, 65) der integrierten Schaltung durchgeführt wird mittels in dem integrierten Schaltkreis enthaltener Regelkreise, die zu dem in dem jeweiligen anderen Schaltungsteil flüßenden Steuerstrom anteil jeweils einen Korrektur-Steuerstrom (Icon) hinzugefügen.

2. Verfahren nach Anspruch 1, **dadurch gekennzeichnet,** daß der Referenz-Schaltungsteil (60) durch den Steuerstrom (Ic) abgeglichen wird.

3. Verfahren nach Anspruch 1 oder 2, **dadurch gekennzeich****net**, daß als Referenz-Schaltungsteil ein Horizontalfrequenz-Oszillator (60) verwendet wird.

4. Verfahren nach einem oder mehreren der Ansprüche 1 bis 3, **dadurch gekennzeichnet**, daß der Abgleich des Referenz-Schaltungsteiles (60) bei der Herstellung von Geräten, die die integrierte Schaltung enthalten, erfolgt.

5. Verfahren nach einem oder mehreren der Ansprüche 1 bis 4, **dadurch gekennzeichnet**, daß zur Einstellung des Steuerstroms (Ic) ein D/A-Wandler (601) verwendet wird, wobei der Steuerstrom einen festgelegten Betrag annimmt, wenn durch eine fortwährende Parity-Prüfung eine unerwünschte Änderung des gespeicherten Betrages für den Steuerstrom detektiert wird.

6. Verfahren nach einem oder mehreren der Ansprüche 1 bis 5, **dadurch gekennzeichnet**, daß der Abgleich durch den Steuerstrom (Ic) bzw. den Korrektur-Steuerstrom (Icon) für Bauelemente in BICMOS- oder Bipolar-Technologie angepaßt ist.

7. Verfahren nach einem oder mehreren der Ansprüche 1 bis 6, **dadurch gekennzeichnet,** daß der tiefpaßgefilterte Anteil der Ausgangsspannung eines mittels des Steuerstroms abzugleichenden FM-Demodulators (624, 634) und/oder das Ausgangssignal einer PLL-Schleife mit einem mittels des Steuerstroms abzugleichenden Referenz-Filter (615) und/oder das Ausgangssignal einer Regelschleife mit einem mittels des Steuerstroms abzugleichenden Referenz-Integrator (674) und/oder das Ausgangssignal einer Regelschleife mit einem Phasenkomparator (642), einem Integrator (644) und einem mittels des Steuerstroms abzugleichenden Glockenkurven-Filter (64) als Maß für den Korrektur-Steuerstrom (Icon) verwendet wird, wobei an den Eingang des (Glockenkurven-Filters (64) periodisch während einer ersten Zeitdauer ein Meßsignal (641) und während einer zweiten Zeitdauer ein bekanntes, zu filterndes Signal angelegt wird und dabei der Korrektur-Steuerstrom (Icon) während der ersten Zeitdauer ermittelt und während der zweiten Zeitdauer sein Betrag beibehalten wird.

8. Verfahren nach Anspruch 7, **dadurch gekennzeichnet**, daß der Steuerstrom während der ersten und zweiten Zeitdauer mit zwei verschiedenen Faktoren (645) zusätzlich geändert wird, wobei insbesondere die erste Zeitdauer die vertikale Rücklaufzeit eines Bildwiedergabegerätes ist.

9. Verfahren nach einem oder mehreren der Ansprüche 1 bis 8, **dadurch gekennzeichnet**, daß der Steuerstrom (Ic) für einen Schaltungsteil oder für mehrere Schaltungsteile zusätzlich temperaturkompensiert (619) wird.

10. Integrierte Schaltung für ein Fernsehsignal-Verarbeitungsgerät, wobei die integrierte Schaltung, einen Horizontalfrequenz-Oszillator (60), Bild-Zf-Filter (611 - 613), Ton-ZF-Filter (614), einen Referenz-Oszillator (615), Filter (621 - 623) und einen FM-Demodulator (624) für einen ersten Tonkanal, Filter (631 - 633) und einen FM-Demodulator (634) für einen zweiten Tonkanal, ein Glockenkurvenfilter (64) eine Chromafalle (65), einen Referenzintegrator (674), einen vertikalen Sync-Separator (671), eine Phi2-Schleifenschaltung (672) und einen Pulsweitenmodulator (673) für ein Switch-Mode-Netzteil enthält, welche mit einem Verfahren nach einem oder mehreren der Ansprüche 1 bis 9 abgeglichen werden.

## Claims

1. Method of adjusting analog circuit sections within an integrated circuit using a control current (Ic) for components contained in the circuit sections and using a common coarse adjustment for a plurality of circuit sections, wherein a value (Iref) corresponding to the magnitude of the control current is stored in the integrated circuit or in a device which contains this integrated circuit, characterised in that, the control current required is determined by the adjustment of a reference circuit section (60) of the integrated circuit and that, automatically, during the operation of the integrated circuit, an additional fine adjustment of another circuit section or of a plurality of other circuit sections (621 - 624, 631 - 634, 614 - 613, 671 - 674, 64, 65) of the integrated circuit is carried out by means of control loops contained in the integrated circuit, which loops add a respective correcting control current (Icon) to the component of the control current flowing in the respective other control current section.

2. Method in accordance with Claim 1, characterised in that, the reference circuit section (60) is adjusted by the control current (Ic).

3. Method in accordance with Claim 1 or 2, characterised in that, a horizontal frequency oscillator (60) is used as the reference circuit section.

4. Method in accordance with one or more of the Claims 1 to 3, characterised in that, the adjustment of the reference circuit section (60) occurs during the manufacture of the devices which contain the integrated circuit.

5. Method in accordance with one or more of the Claims 1 to 4, characterised in that, a D/A converter (601) is used for setting the control current (Ic) whereby the control current adopts a predetermined value if an unwanted alteration of the stored magnitude for the control current is detected during a continual parity check.

6. Method in accordance with one or more of the Claims 1 to 5, characterised in that, the adjustment by the control current (Ic) or the correcting control current (Icon) is adapted for BICMOS or bipolar components.

7. Method in accordance with one or more of the Claims 1 to 6, characterised in that, the low pass filtered component of the output voltage of an FM demodulator (624, 634) which is to be adjusted by means of the control current and/or the output signal of a PLL loop including a reference filter (615) which is to be adjusted by means of the control current and/or the output signal of a control loop including a reference integrator (674) which is to be adjusted by means of the control current and/or the output signal of a control loop including a phase comparator (642), an integrator (644) and a bell curve filter (64) which is to be adjusted by means of the control current is used as a measure for the correcting control current (Icon), wherein a test signal (641) is periodically applied to the input of the bell curve filter (64) during a first time period and a known signal that is to be filtered is applied during a second time period and the correcting control current (Icon) is thereby determined during the first time period and its magnitude is maintained during the second time period.

8. Method in accordance with Claim 7, characterised in that, the control current is additionally altered by two different factors (645) during the first and second time periods, wherein the first time period in particular is the vertical flyback period of a picture reproducing apparatus.

9. Method in accordance with one or more of the Claims 1 to 8, characterised in that, the control current (Ic) for a circuit section or for a plurality of circuit sections is additionally temperature compensated (619).

10. Integrated circuit for a television signal processing device wherein the integrated circuit contains, a horizontal frequency oscillator (60), image IF filters (611 - 613), sound IF filters (614), a reference oscillator (615), filters (621 - 623) and an FM demodulator (624) for a first sound channel, filters (631 - 633) and an FM demodulator (634) for a second sound channel, a bell curve filter (64), a chroma trap (65), a reference integrator (674), a vertical sync separator (671), a Phi2 loop circuit (672) and a pulse width modulator (673) for a switched-mode mains power unit, which are adjusted using a method in accordance with one or more of the Claims 1 to 9.

## Revendications

1. Procédé d'égalisation d'éléments de circuit analogiques à l'intérieur d'un circuit intégré avec un courant de commande (Ic) pour les modules contenus dans les éléments de circuit et avec une égalisation approximative de plusieurs éléments de circuit, une valeur (Iref), correspondant à la valeur du courant de commande, étant mise en mémoire dans le circuit intégré ou dans un dispositif contenant ce circuit intégré **caractérisé en ce que** le courant de commande nécessaire est déterminé au moyen de l'égalisation d'un élément de circuit de reférence (60) du circuit intégré, et **en ce que** s'opère automatiquement, pendant le fonctionnement du circuit intégré, une égalisation fine supplémentaire d'un autre ou de plusieurs autres éléments de circuit (621-624, 631-634, 614-613, 671-674, 64, 65) du circuit intégré au moyen de circuits de régulation compris dans le circuit intégré, ces circuits de régulation ajoutant à la fraction de courant circulant dans les autres éléments de circuit un courant de correction (Icon).

2. Procédé selon la revendication 1 **caractérisé en ce** **que** l'élément de circuit de référence (60) est égalisé par le courant de commande (Ic).

3. Procédé selon la revendication 1 ou 2 **caractérisé** **en ce qu**'on utilise un oscillateur de fréquence horizontale (60) comme élément de circuit de référence.

4. Procédé selon une ou plusieurs des revendications 1 à 3 **caractérisé en ce que** l'égalisation de l'élément de circuit de référence (60) se fait lors de la fabrication des appareils contenant le circuit intégré.

5. Procédé selon l'une ou plusieurs des revendications 1 à 4 **caractérisé en ce qu**'on utilise un convertisseur numérique/analogique (601) pour le réglage du courant de commande (Ic), ce courant prenant une valeur déterminée, lorsqu'une modification non voulue de la valeur du courant de commande mémorisée a été détectée au moyen d'un test de parité.

6. Procédé selon l'une ou plusieurs des revendications 1 à 5 **caractérisé en ce que** l'égalisation au moyen du courant de commande (Ic) ou du courant de correction (Icon) est adapté aux modules de la technologie BICMOS ou bipolaire.

7. Procédé selon l'une ou plusieurs des revendications 1 à 6 **caractérisé en ce que** la fraction de la tension de sortie filtrée au passe-bas d'un démodulateur MF (624, 634) à égaliser et/ou le signal de sortie d'une boucle PLL, cette boucle comprenant un filtre de référence (615) à égaliser au moyen du courant de commande, et/ou le signal de sortie d'une boucle de régulation comprenant un intégrateur de référence (674) à égaliser au moyen du courant de commande, et/ou le signal de sortie d'une boucle de régulation comprenant un comparateur de phases (642), un intégrateur (644) et un filtre de courbe en cloche (64) à égaliser au moyen du courant de commande est utilisé comme mesure de repère pour le courant de correction (Icon), un signal de mesure (641) étant périodiquement placé à l'entrée du filtre de courbe en cloche (64) pendant une première durée et un signal connu, à filtrer étant placé à l'entrée du filtre de courbe en cloche pendant une seconde durée, le courant de correction (Icon) étant ainsi déterminé pendant la première durée et la valeur de ce courant étant conservée pendant la seconde durée.

8. Procédé selon la revendication 7 **caractérisé en ce que** le courant de commande est remodifié avec deux coefficients différents (645) pendant la première et la seconde durée, la première durée étant notamment le retour de balayage vertical d'un appareil de reproduction d'images.

9. Procédé selon l'une ou plusieurs des revendications 1 à 8 **caractérisé en ce que** le courant de commande (Ic) pour un ou plusieurs éléments de circuit est de plus compensé en température (619).

10. Circuit intégré pour un appareil de traitement de vidéosignaux comprenant un oscillateur de fréquence verticale (60), des filtres de fréquence intermédiaire vidéo (611-613), des filtres de fréquence intermédiaire audio (614), un oscillateur de référence (615), des filtres (621-623) et un démodulateur MF (624) pour un premier canal son, des filtres (631-633) et un démodulateur MF (634) pour un second canal son, un filtre de courbe en cloche (64), un piège à chroma (65), un intégrateur de référence (674), un séparateur synchrone vertical (671), un montage en boucle Phi2 (672) et un modulateur d'impulsions en largeur (673) pour un bloc d'alimentation de mode switch, tous ces éléments étant égalisés selon l'une ou plusieurs des revendications 1 à 9.
